# EUROPÄISCHE PATENTANMELDUNG

(11) **EP 2 254 163 A2**
(43) Veröffentlichungstag der Anmeldung: **24.11.2010**
(21) Anmeldenummer: 10005162.2
(22) Anmeldetag: 18.05.2010
(51) Int. Cl.: H01L 31/18

(54) **Verfahren zur Herstellung eines photovoltaischen Moduls**

(30) Priorität: 22.05.2009 DE 102009022318
(71) Anmelder: SCHOTT Solar AG, 55122 Mainz (DE)
(72) Erfinder: Wagner, Hermann, Dr., 07745 Jena (DE); Reuner, Jörg, 81739 München (DE); Psyk, Walter, 81371 München (DE)
(74) Vertreter: von Puttkamer · Berngruber

(57) **Zusammenfassung**

Zur Herstellung eines photovoltaischen Moduls mit einem transparenten Substrat (1), einer transparenten Frontelektrodenschicht (2), einer Halbleiterschicht (3) aus mikrokristallinem oder mikromorphem Silizium und einer Rückelektrodenschicht (4), welche in einzelne, durch Trennlinien (5, 6, 7) elektrisch voneinander getrennte Zellen (C1, C2, C3) strukturiert sind, welche in Serie geschaltet sind, werden zumindest in der Rückelektrodenschicht (4) mit einem Laserstrahl (14) Trennlinienabschnitte (18, 18') erzeugt, die durch in einem Winkel (α) zu den Trennlinienabschnitten (18, 18`) verlaufende Verbindungsabschnitte (19, 20) zu durchgehenden Trennlinien (7) verbunden werden.

## Beschreibung

Die Erfindung betrifft ein Verfahren zur Herstellung eines photovoltaischen Moduls nach dem Oberbegriff des Anspruchs 1.

Bei der Herstellung von photovoltaischen Modulen mit einer Halbleiterschicht aus amorphem, mikrokristallinem oder mikromorphem Silizium werden in der Regel Glasscheiben als Substrat mit einer transparenten Frontelektrodenschicht, der Halbleiterschicht und einer Rückelektrodenschicht als photovoltaisch aktive Schichten ganzflächig beschichtet.

Die monolithischen Schichten werden z. B. mittels Laser in einzelne, durch Trennlinien elektrisch voneinander getrennte streifenförmige Zellen strukturiert, die Serie geschaltet werden, um ein Modul mit einer gewünschten Spannung von z. B. 12 Volt zu erhalten.

Zur Strukturierung ist der Laser in ein Strukturierungssystem integriert, typischerweise ein X-Y-Koordinatentisch, ein Split-Axis-System oder ein Portal- oder Gantry-System.

So wird beispielsweise beim Split-Axis-System ein Laserstrahl zu einer oder mehreren sich bewegenden Fokussieroptiken geleitet, die in der X-Achse nebeneinander angeordnet sind und den Laserstrahl in die Funktionsschichten fokussieren. In Richtung der zweiten oder Y-Achse, in der sich die Trennlinien erstrecken, wird das beschichtete Substrat unter den Fokussieroptiken hindurch bewegt. Die Trennlinien können dabei in einem Hub, also als durchgehende Linie über die gesamte Länge der photovoltaisch aktiven Schicht erzeugt werden. Statt dessen können die Trennlinien auch aus Abschnitten zusammengesetzt werden, d. h. die durchgehende Trennlinie kann sequentiell aus einzelnen Trennlinienabschnitten hergestellt werden.

Gegenüber der Bildung durchgehender Trennlinien in einem Hub werden durch diesen sequentiellen Trennlinienaufbau aus Trennlinienabschnitten die Produktionskosten pro Modul deutlich herabgesetzt werden.

Zwar hat sich dieser sequentielle Trennlinienaufbau bei Modulen in einer Halbleiterschicht aus amorphem Silizium als geeignet erwiesen. Bei einem sequentiellen Trennlinienaufbau der Rückelektrodenschicht von Modulen mit einer mikrokristallinen oder mikromorphen Silizium-Halbleiterschicht können jedoch Fehlfunktionen, z. B. ein elektrischer Kurzschluss des photovoltaischen Moduls auftreten.

Aufgabe der Erfindung ist es, einwandfrei funktionierende photovoltaische Module mit einer mikrokristallinen oder mikromorphen Silizium-Halbleiterschicht mit möglichst geringen Produktionskosten herzustellen.

Dies wird erfindungsgemäß mit dem im Anspruch 1 gekennzeichneten Verfahren erreicht. Vorteilhafte Ausgestaltungen der Erfindung sind in den Unteransprüchen angegeben.

Nach der Erfindung wird zumindest in der Rückelektrodenschicht ein sequentielle Trennlinienaufbau durchgeführt. Die einzelnen Trennlinienabschnitte können dabei z. B. mit einem Laserscanner mit einem Zwei-Achsen-Galvanometer erzeugt werden.

Durch diesen sequentiellen Trennlinienaufbau können zwar die Kosten zur Herstellung der Trennlinien herabgesetzt werden. Anders als bei einer amorphen Silizium-Halbleiterschicht, die relativ dünn ist, kann eine mikrokristalline oder mikromorphe Silizium-Halbleiterschicht jedoch eine um ein Vielfaches höhere Schichtdicke aufweisen. Wenn der Laserstrahl die Rückelektrodenschicht abtastet, führt dies dazu, dass sich die dicke mikrokristalline oder mikromorphe Silizium-Halbleiterschicht unter der Rückelektrodenschicht thermisch so aufheizt, dass die Rückelektrodenschicht zusammen mit der Halbleiterschicht unter Bildung der Trennlinienabschnitte abgesprengt wird.

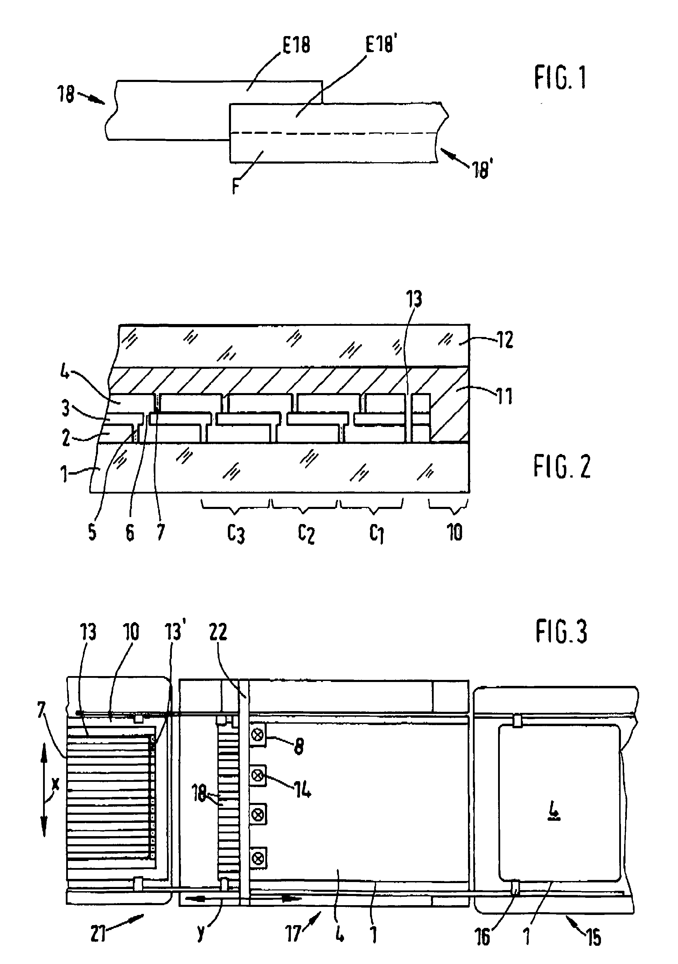

Wenn, wie in Figur 1 dargestellt, die überlappenden Endabschnitte E18 und E18' des ersten Trennlinienabschnitts 18 und des zweiten Trennlinienabschnitts 18' nicht miteinander fluchten, sondern versetzt zueinander verlaufen, kann, wie festgestellt werden konnte, in dem Bereich F des Endabschnitts E18 des zweiten Trennlinienabschnitts 18' kein vollständiges Absprengen der Rückkontaktschicht erfolgen, vielmehr kann das Rückkontaktschichtmaterial zusammen mit dem Halbleitermaterial in dem Bereich F von der transparenten Frontelektrodenschicht weg nach oben gebogen werden, sodass aus dem Material der Rückkontaktschicht in dem Bereich F elektrisch leitende Flitter entstehen können, die zu Fehlfunktionen des Moduls, insbesondere einem Kurzschluss führen.

Um diese Flitterbildung zu verhindern, werden erfindungsgemäß mit dem Laserstrahl Verbindungsabschnitte erzeugt, die in einem Winkel zu den Trennlinien verlaufen und die Trennlinienabschnitte miteinander verbinden. Die Verbindungsabschnitte verlaufen dabei zu den Trennlinien vorzugsweise in einem Winkel von 10 bis 90°, insbesondere 30 bis 90°.

Der Verbindungsabschnitt kann durch den Endabschnitt wenigstens eines der beiden miteinander verbundenen Trennlinienabschnitte der Rückelektrodenschicht gebildet werden. Statt dessen kann der Verbindungsabschnitt durch einen separaten Abschnitt zwischen den beiden zu verbindenden Trennlinienabschnitten gebildet werden.

Mit dem erfindungsgemäßen Verfahren wird die Rückelektrodenschicht strukturiert, die auf einer Halbleiterschicht aus mikrokristallinem oder mikromorphem Silizium abgeschieden ist. Gegenüber amorphem Silizium wird mit einer mikrokristallinen oder mikromorphen Silizium-Halbleiterschicht ein höherer Wirkungsgrad erzielt.

Während mikrokristallines Silizium aus Siliziumkristallen mit einer Teilchengröße im Mikrometerbereich besteht, stellt mikromorphes Silizium eine Tandemschicht aus einer Teilschicht aus amorphem Silizium an der Licht zugewandten Seite des Moduls und einer Teilschicht aus mikrokristallinem Silizium dar.

Die Schichtdicke der mikrokristallinen oder mikromorphen Silizium-Halbleiterschicht des Moduls beträgt vorzugsweise mindestens 0,6, insbesondere mindestens 1 µm und kann z. B. 2 µm oder gar 3 µm betragen.

Die transparente Frontelektrodenschicht kann aus einem elektrisch leitfähigen Metalloxid, beispielsweise Zinnoxid, Zinkoxid oder einem anderen Material bestehen. Die Rückelektrodenschicht wird vorzugsweise durch eine Metallschicht gebildet, beispielsweise aus Aluminium oder Silber. Das Substrat kann durch eine Glasplatte oder ein anderes transparentes, elektrisch isolierendes Material gebildet werden.

Die Laserstrukturierung kann mit einem Split-Axis-System, einem Gantry-System oder mit einem x-y-Koordinatentisch durchgeführt werden.

Beim Split-Axis-System wird mindestens ein Laserstrahl zu einem oder mehreren Laserköpfen geleitet, die eine Fokussieroptik aufweisen und entlang der X-Richtung bewegbar sind. Durch den Laserkopf wird der Laserstrahl in die Rückelektrodenschicht fokussiert. In der zweiten oder Y-Richtung wird das photovoltaische Modul unter dem oder den Laserköpfen hindurch bewegt. Dabei stellt die Y-Richtung die Richtung dar, in der die Trennlinien zur Strukturierung der Rückelektrodenschicht verlaufen, während die X-Richtung dazu normalerweise senkrecht verläuft.

Beim Gantry-System wird das photovoltaische Modul nicht bewegt. Statt dessen sind an einem Portal ein oder mehrere Laserköpfe angeordnet, die entlang dem Portal in X-Richtung bewegbar sind, während das Portal in Y-Richtung verfahrbar ist. Beim x-y-Koordinatentisch wird das am Tisch befestigte Modul unter dem oder den feststehenden Laserköpfen in X- und Y-Richtung bewegt.

Es ist nicht notwendig, dass jeder Laserkopf eine eigene Laserquelle besitzt. Vielmehr kann der Laserstrahl der Laserquelle in Teilstrahlen geteilt werden, wobei jeder Teilstrahl zu einem Laserkopf geleitet wird, der den Laserstrahl mit seiner Fokussieroptik in die Rückelektrodenschicht fokussiert.

Um vor Witterungs- und anderen Umwelteinflüssen geschützt zu sein, werden die photovoltaisch aktiven Schichten verkapselt. Dazu wird eine Rückseitenabdeckung, beispielsweise eine Glasplatte verwendet, die mit einer Klebefolie auflaminiert wird. Damit die Rückseitenabdeckung mit der Klebefolie direkt mit dem Substrat verbunden werden kann, werden die photovoltaisch aktiven Schichten im Randbereich des Moduls entfernt.

Neben dieser Randentschichtung, die ebenfalls mit einem Laser durchgeführt werden kann, werden die photovoltaisch aktiven Schichten gegenüber dem Randbereich des Moduls zusätzlich durch eine Isolationstrennlinie elektrisch isoliert.

Die Isolationstrennlinie in der Rückelektrodenschicht wird vorzugsweise ebenfalls mit einem Laserstrahl sequentiell erzeugt. Das heißt, mit dem Laserstrahl werden in der Rückelektrodenschicht Isolationstrennlinienabschnitte gebildet, die durch Verbindungsabschnitte in der Rückelektrodenschicht zu durchgehenden Isolationstrennlinien verbunden werden. Die Verbindungsabschnitte verlaufen zu den Isolationstrennlinienabschnitten in einem Winkel von vorzugsweise 10 bis 90°, insbesondere 30 bis 90°. Der Verbindungsabschnitt kann durch den Endabschnitt wenigstens eines der beiden zu verbindenden Isolationstrennlinienabschnitte in der Rückelektrodenschicht oder durch einen separaten Abschnitt zwischen den Endabschnitten der Isolationstrennlinienabschnitte gebildet sein.

Die Isolationstrennlinien umschließen die photovoltaisch aktiven Schichten des normalerweise rechteckigen Moduls. Das heißt, zwei Isolationstrennlinien an gegenüberliegenden Seiten des Moduls erstrecken sich in Y-Richtung parallel zu den Strukturierungstrennlinien, während sich die beiden anderen Isolationstrennlinien an den beiden gegenüberliegenden Seiten des Moduls in X-Richtung erstrecken.

Die Isolationstrennlinien in Y-Richtung in der Rückelektrodenschicht können in gleicher Weise wie die Strukturierungstrennlinien aus Isolationstrennlinienabschnitten gebildet werden, die durch Verbindungsabschnitte z. B. an den Endabschnitten der Isolationstrennlinienabschnitte oder durch separate Verbindungsabschnitte verbunden sind.

Demgegenüber können für die Isolationstrennlinienabschnitte, aus denen die in X-Richtung verlaufenden Isolationstrennlinien in der Rückelektrodenschicht gebildet werden, als Verbindungsabschnitte die in Y-Richtung verlaufenden Trennlinien zur Strukturierung der Rückelektrodenschicht verwendet werden.

Vorzugsweise wird zur Strukturierung der Rückelektrodenschicht ein Laser verwendet, der Laserlicht im sichtbaren Bereich emittiert, beispielsweise ein Neodym dotierter Festkörperlaser, insbesondere ein Neodym dotierter Yttrium-Vanadat-Laser (Nd:YVO₄-Laser) oder Neodym dotierter Yttrium-Aluminium-Granat-Laser (Nd:YAG-Laser) mit einem Laserlicht der zweiten harmonischen Wellenlänge von 532 nm.

Die Strukturierung der Rückelektrodenschicht wird vorzugsweise bei gepulstem Laserbetrieb durchgeführt, beispielsweise mit einem Güte-Schalter (Q-Switch--Betrieb). D.h. der Laser ist vorzugsweise CW gepumpt und gütegeschaltet. Die Laserspots können dabei mit Überlappung unmittelbar aneinander gesetzt werden. Die relative Geschwindigkeit zwischen Laserstrahl und Substratoberfläche sollte mindestens 1000 mm/sec betragen und die Laserstrahlenergiedichte mindestens 100 mJ/cm².

Die Laserstrukturierung der Rückelektrodenschicht kann beispielsweise auch mit der dritten harmonischen Wellenlänge von 355 nm des Neodym dotierten Festkörperlasers durchgeführt werden oder mit dessen Grundwelle von 1064 nm.

Beispielsweise kann die Laserstrahlung mit einer Wellenlänge von 1064 nm durch das transparente Substrat auf die Frontelektrodenschicht gerichtet werden, die sich dadurch thermisch so aufheizt, dass die darüber liegende mikrokristalline oder mikromorphe Silizium-Halbleiterschicht zusammen mit der Rückelektrodenschicht thermisch entfernt werden und damit eine Strukturierung der Rückelektrodenschicht erfolgt. Zwar werden dadurch bei der Strukturierung der Rückelektrodenschicht zusätzliche Trennlinien in der Halbleiterschicht gebildet, die sich jedoch auf die Leistung des photovoltaischen Moduls praktisch nicht auswirken.

Zur Strukturierung der Rückelektrodenschicht kann der Laserstrahl direkt auf die Rückelektrodenschicht gerichtet. Die Strukturierung der Rückelektrodenschicht kann jedoch auch mit einem Laserstrahl von der anderen Seite, also durch das transparente Substrat hindurch durchgeführt werden.

Die Beschichtung des Substrats mit der Frontelektrodenschicht und der mikrokristallinen oder mikromorphen Silizium-Halbleiterschicht kann beispielsweise durch Gasphasenabscheidung erfolgen, die Beschichtung der Halbleiterschicht mit der Rückelektrodenschicht beispielsweise durch Sputtern.

Unter Trennlinien sind erfindungsgemäß sowohl Verschaltungslinien wie Isolationslinien zu verstehen.

Nachstehend ist die Erfindung anhand der beigefügten Zeichnung beispielhaft näher erläutert. Darin zeigen:
Figur 1 eine Draufsicht auf die Endabschnitte von zwei zu verbindenden Trennlinienabschnitten in der Rückelektrodenschicht, die versetzt zueinander angeordnet sind;
Figur 2 einen Schnitt durch einen Teil eines photovoltaischen Moduls mit serienverschalteten Zellen;
Figur 3 die Vorderansicht einer Anlage zur Erzeugung der Trennlinien in der Rückelektrodenschicht;
Figur 4 eine Draufsicht auf zwei in Y-Richtung nebeneinander angeordnete Felder mit Trennlinienabschnitten in der Rückelektrodenschicht;
Figur 5 und 6 eine vergrößerte Wiedergabe der Bereichs A in

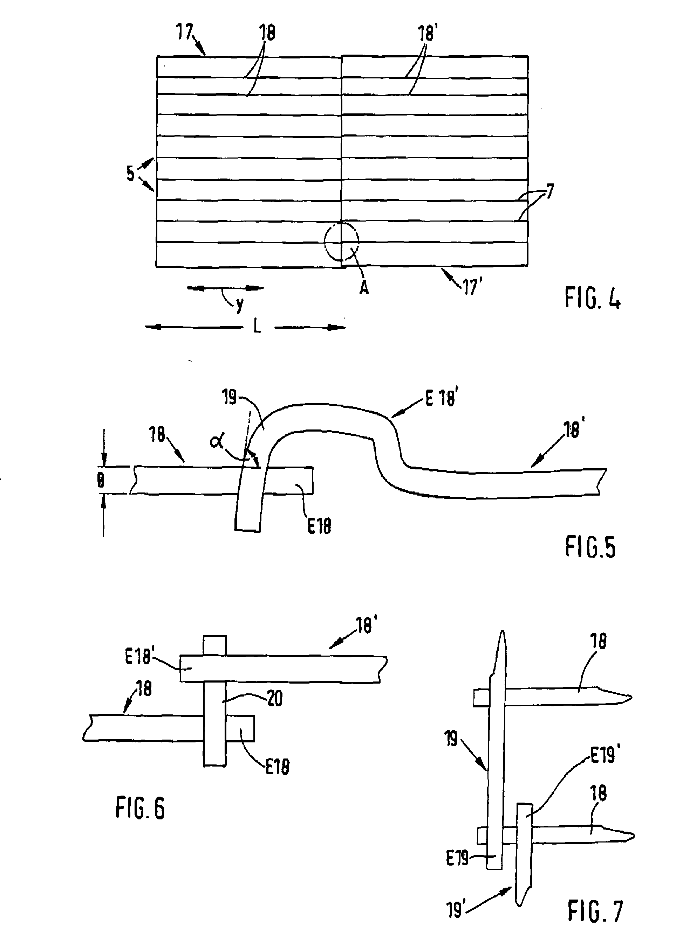

Figur 4 mit einem Verbindungsabschnitt zwischen zwei Trennlinienabschnitten nach einer ersten bzw. zweiten Ausführungsform der Erfindung; und
Figur 7 eine Draufsicht auf zwei mit einer Strukturierunqstrennlinie verbundene Isolationstrennlinienabschnitte.

Gemäß Figur 2 weist ein transparentes Substrat 1, beispielsweise eine Glasscheibe, eine transparente Frontelektrodenschicht 2, eine photovoltaische Halbleiterschicht 3 aus mikrokristallinem oder mikromorphem Silizium und eine Rückelektrodenschicht 4 auf, die mit Trennlinien 5, 6 bzw. 7 versehen sind, um serienverschaltete streifenförmige Zellen C1, C2, ... zu bilden.

Im Randbereich 10 des Moduls 1 sind die Schichten 3, 4, 5 entfernt. Mit der Klebefolie 11 ist auf die mit den Schichten 2, 3, 4 versehene Seite des Substrats 1 eine Rückseitenabdeckung 12, beispielsweise eine Glasscheibe auflaminiert. Damit ist das Substrat 2 im Randbereich 10 mit der Klebefolie 11 direkt mit der Rückseitenabdeckung 12 fest verbunden, wodurch die Schichten 2 bis 4 versiegelt werden. Um die Schichten 2, 3, 4 gegenüber dem Randbereich 10 zusätzlich zu isolieren, ist in den Schichten 3 und 4, einschließlich der Rückelektrodenschicht 4 eine Isolationstrennlinie 13 vorgesehen.

Die Strukturierungstrennlinien 5, 6, 7 und die Isolationstrennlinie 13 werden mit einem Laserstrahl 14 erzeugt.

Gemäß Figur 3 weist eine Anlage zur Bildung der Trennlinien 5, 6, 7, 13 eine Beladestation 15 auf, an der das beschichtete Substrat 1 mit einer Aufnahme 16 fixiert ist. Von der Beladestation 15 wird das beschichtete Substrat 1 zu der Bearbeitungsstation 17 in Y-Richtung bewegt, an der die Trennlinien 17 (Figur 4) unter anderem in der Rückelektrodenschicht 4 erzeugt werden und von dort zu der Entladestation 21.

Die Bearbeitungsstation 17 weist mehrere Laserköpfe 8 mit jeweils einer Fokussieroptik auf (z.B. Galvo Scankopf mit f-Theta Objektiv), um einen Laserstrahl 14 in die Rückelektrodenschicht 4 zu fokussieren. Die Laserköpfe 8 sind an einer als Portal ausgebildeten Halterung.22 befestigt und sind sich in X-Richtung quer über die zu strukturierende Rückelektrodenschicht 4 auf dem Substrat 1 verteilt. Dabei versehen alle Laserköpfe 8 gleichzeitig das jeweils darunter liegende Feld 17 mit den sich über die gesamte Länge L jedes Feldes 17 erstreckenden Trennlinienabschnitten 18 (Figur 4). Die einzelnen Felder 17 schließen dabei in X-Richtung aneinander an. Damit wird die Rückelektrodenschicht 4 über ihre gesamte Breite mit parallelen Trennlinienabschnitten 18 versehen, die eine den Feldern 17 entsprechende Länge L aufweisen. Im nächsten Schritt wird das Substrat 1 in Y-Richtung bewegt und zwar um einen Abstand, der höchstens der Lange L der Felder 17 entspricht. Alsdann wird mit jedem Laserkopf 8 eine zweite sich über die gesamte Breite des Substrats 1 erstreckende Reihe von parallelen Trennlinienabschnitten 18' in dem Feld 17' gebildet. Dieser Vorgang wird solange wiederholt, bis die Trennlinienabschnitte 18, 18' sich in Y-Richtung über die gesamte Länge des Substrats 1 erstreckende Trennlinien 7 in der Rückelektrodenschicht 4 bilden.

Wenn die Laserköpfe mit einer Festoptik ohne Galvo-Scanner ausgestattet sind, wird in den Feldern 17 jeweils nur ein Trennlinenabschnitt pro Bewegung der X-Achse generiert. Die so generierten Trennlinenabschnitte werden zu einer durchgehenden Trennlinie zusammengesetzt und zwar entweder durch sequenziellen Versatz der Laserköpfe in X- oder Y-Richtung.

Wie in Figur 4 dargestellt, ist es praktisch nicht möglich, dass die Trennlinienabschnitte 18, 18' benachbarter Felder 17, 17' exakt miteinander fluchten. Dadurch entstehen beim Lasern der Trennlinien 7 in der Rückelektrodenschicht 4 aus dem Material der Rückelektrodenschicht 4 Flitter, die zu Fehlfunktionen der photovoltaischen Moduls führen können, wie dies vorstehend anhand der Figur 1 erläutert worden ist.

Gemäß Figur 5 und 6 werden daher mit den Laserköpfen 8 Verbindungsabschnitte 19, 20 in die Rückelektrodenschicht 4 gelasert, die in einem Winkel α zu den Trennabschnitten 18, 18' verlaufen, um die zueinander versetzt angeordneten Trennlinienabschnitte 18, 18' ohne Bildung derartiger Flitter zu verbinden.

Gemäß Figur 5 wird dabei der Verbindungsabschnitt 19 durch einen hakenförmigen Endabschnitt E18' an dem Trennlinienabschnitt 18' gebildet. Dabei schneidet der Verbindungsabschnitt 19 an dem Endabschnitt E18' des Trennlinienabschnitts 18' den Endabschnitt E18 des Trennlinienabschnitts 18 mit einem Winkel α von ca. 80°.

Gemäß Figur 6 wird der Verbindungsabschnitt 20 durch einen separaten Abschnitt gebildet, der senkrecht zu den Endabschnitten E18 und E18' der beiden Trennlinienabschnitte 18, 18' verläuft.

Die Breite B der Trennlinienabschnitte 18, 18' und damit der Trennlinien 7 in der Rückelektrodenschicht 4 kann beispielsweise 50 bis 150 µm betragen. Damit können die miteinander zu verbindenden Trennlinienabschnitte 18, 18' um das Doppelte und mehr der Breite B der Trennlinienabschnitte 18, 18' versetzt sein. Der separate Verbindungsabschnitt 20 nach Figur 7 weist die gleiche Breite B wie die Trennabschnitte 18, 18' auf.

Mit den Laserköpfen 8 werden auch die die photovoltaisch aktiven Schichten 2, 3, 4 umschließenden Isolationstrennlinien 13, 13' erzeugt (Figur 2 und 3).

Die beiden sich in Y-Richtung erstreckenden Isolationstrennlinien 13 werden dabei in gleicher Weise sequentiell mit der Laserköpfen 8 hergestellt, wie die Strukturierungstrennlinien 7 aus den Strukturierungstrennlinienabschnitten 18, 18', die entsprechend Figuren 5 und 6 verbunden werden können.

Die in X-Richtung verlaufenden Isolationstrennlinien 13' werden bei feststehendem Substrat 1 durch Bewegung der Laserköpfe 8 in X-Richtung entlang der Halterung 22 gemäß Figur 3 gebildet.

In Figur 7 sind die Endabschnitte E19, 19' von zwei Isolationstrennlinienabschnitten 19', 19' in der Rückelektrodenschicht 4 dargestellt, die durch einen der Strukturierungstrennlinienabschnitte 18 miteinander verbunden werden.

## Patentansprüche

1. Verfahren zur Herstellung eines photovoltaischen Moduls mit einem transparenten Substrat (1) und photovoltaisch aktiven Schichten mit einer transparenten Frontelektrodenschicht (2), einer Silizium-Halbleiterschicht (3) und einer Rückelektrodenschicht (4), welche in einzelne durch Trennlinien (5, 6, 7) elektrisch voneinander isolierte Zellen (C₁, C₂, C₃) strukturiert werden, die in Serie geschaltet sind, wobei zumindest die Strukturierung der Rückelektrodenschicht (4) mit einem Laserstrahl (14) durchgeführt wird, **dadurch gekennzeichnet, dass** die Silizium-Halbleiterschicht (3) aus mikrokristallinem oder mikromorphem Silizium besteht und mit dem Laserstrahl (14) zumindest in der Rückelektrodenschicht (4) Trennlinienabschnitte (18, 18') sowie in einem Winkel (α) zu den Trennlinienabschnitten (18, 18') verlaufende Verbindungsabschnitte (19, 20) erzeugt werden, die die Trennlinienabschnitte (18, 18') zu einer durchgehenden Trennlinie (7) verbinden.

2. Verfahren nach Anspruch 1, **dadurch gekennzeichnet, dass** der Verbindungsabschnitt (19, 20) zu den Trennlinienabschnitten (18, 18') in einem Winkel (α) von 10 bis 90° verläuft.

3. Verfahren nach Anspruch 1 oder 2, **dadurch gekennzeichnet, dass** der Verbindungsabschnitt (19) durch den Endabschnitt (E18') wenigstens eines der beiden zu verbindenden Trennlinienabschnitte (18, 18') in der Rückelektrodenschicht (4) gebildet wird.

4. Verfahren nach Anspruch 1 oder 2, **dadurch gekennzeichnet, dass** der Verbindungsabschnitte (20) durch einen separaten Abschnitt zwischen den Endabschnitten (E18, E18') der Trennlinienabschnitte (18, 18') gebildet wird.

5. Verfahren nach Anspruch 1, **dadurch gekennzeichnet, dass** zur elektrischen Isolierung der photovoltaisch aktiven Schichten (2, 3, 4) gegenüber dem Randbereich (10) des Moduls mit dem Laserstrahl (14) zumindest in der Rückelektrodenschicht (4) eine Isolationstrennlinie (13, 13') gebildet wird, wobei mit dem Laserstrahl (14) Isolationstrennlinienabschnitte (19, 19') erzeugt werden, die durch Verbindungsabschnitte in der Rückelektrodenschicht (4), die im Winkel zu den Isolationstrennlinienabschnitten (19, 19') verlaufen, zu durchgehenden Isolationstrennlinien (13, 13') verbunden werden.

6. Verfahren nach Anspruch 5, **dadurch gekennzeichnet, dass** der Verbindungsabschnitt, der die Isolationstrennlinienabschnitte (19, 19') zu einer durchgehenden Isolationstrennlinie (13) verbindet, durch einen Endabschnitt wenigstens einer der beiden miteinander verbundenen Trennlinienabschnitte (Fig. 5) oder durch einen Trennlinienabschnitt (18) zur Strukturierung der Rückelektrodenschicht (4) gebildet wird.

7. Verfahren nach Anspruch 1, **dadurch gekennzeichnet, dass** die mikrokristalline oder mikromorphe Silizium-Halbleiterschicht (3) eine Schichtdicke von 0,6 bis 3 µm aufweist.

8. Verfahren nach Anspruch 1, **dadurch gekennzeichnet, dass** zur Laserstrukturierung der Rückelektrodenschicht (4) ein gepulster Laser (15) verwendet wird.

9. Verfahren nach Anspruch 1, **dadurch gekennzeichnet, dass** zur Laserstrukturierung der Rückelektrodenschicht (4) ein Laser (15) verwendet wird, der Licht im sichtbaren Bereich emittiert.

10. Verfahren nach Anspruch 9, **dadurch gekennzeichnet,**
**dass** als Laser (15) ein frequenzverdoppelter Neodym dotierter Festkörperlaser verwendet wird, der Laserlicht mit einer Wellenlänge von 532 nm emittiert.
